# EUROPÄISCHE PATENTSCHRIFT

(11) **EP 2 051 091 B1**
(45) Veröffentlichungstag und Bekanntmachung des Hinweises auf die Patenterteilung: **09.09.2015**
(21) Anmeldenummer: 08017940.1
(22) Anmeldetag: 14.10.2008
(51) Int. Cl.: G01R 33/30, G01R 33/3415, G01R 33/36, G01R 33/46, G01R 33/34, G01R 33/341

(54) **NMR-Messkopf mit mehreren Resonatorsystemen zur simultanen Vermessung mehrerer Messproben in einer gekoppelten Mode**
NMR probe with several resonators for the simultaneous measurement of several test samples in a coupled mode
Sonde RMN dotée de plusieurs résonateurs destinée à la mesure simultanée de plusieurs échantillons dans un mode couplé

(30) Priorität: 17.10.2007 DE 102007049701
(43) Veröffentlichungstag der Anmeldung: 22.04.2009
(73) Patentinhaber: Bruker BioSpin AG, 8117 Fällanden (CH)
(72) Erfinder: Freytag, Nicolas, 8122 Binz (CH)
(74) Vertreter: Kohler Schmid Möbus Patentanwälte

(56) Entgegenhaltungen:
- US-B1- 6 456 072
- US-B1- 7 271 592
- MACNAUGHTAN M A ET AL: "High-Throughput Nuclear Magnetic Resonance Analysis Using a Multiple Coil Flow Probe" ANALYTICAL CHEMISTRY, AMERICAN CHEMICAL SOCIETY, US, Bd. 75, 1. Januar 2003 (2003-01-01), Seiten 5116-5123, XP002457864 ISSN: 0003-2700
- LAZOVIC J ET AL: "Hexagonal zero mode TEM coil: a single-channel coil design for imaging multiple small animals" MAGNETIC RESONANCE IN MEDICINE, ACADEMIC PRESS, DULUTH, MN, US, Bd. 53, Nr. 5, 1. Mai 2005 (2005-05-01), Seiten 1150-1157, XP007910738 ISSN: 0740-3194
- DARASSE L ET AL: "Perspectives with cryogenic RF probes in biomedical MRI" BIOCHIMIE, MASSON, PARIS, FR, Bd. 85, 1. Januar 2003 (2003-01-01), Seiten 915-937, XP002463819 ISSN: 0300-9084

## Beschreibung

Die Erfindung betrifft einen Kernspinresonanz(=NMR)-Messkopf, umfassend N Grundelemente, mit N ≥ 2, wobei jedes Grundelement eine zylinderförmige Messprobe und ein Resonatorsystem aufweist,
wobei die N Messproben eine identische Messsubstanz enthalten,
wobei ein Kopplungsnetzwerk für die N Resonatorsysteme vorgesehen ist, mit dem die Gesamtheit der N Resonatorsysteme beim Senden und Empfangen in einem identischen, gekoppelten Mode betreibbar ist,
wobei die N Resonatorsysteme der N Grundelemente zur Einrichtung des gekoppelten Mode durch elektromagnetische Kopplung miteinander verschaltet sind,
und wobei das Kopplungsnetzwerk für die Gesamtheit der N Resonatorsysteme einen gemeinsamen Empfänger-Schaltkreis umfasst.

Ein solcher NMR-Messkopf ist beispielsweise aus M.A. Macnaughtan et al., Anal. Chem. 2003 (75), 5116-5123, bekannt geworden.

NMR-Spektroskopie ist ein leistungsfähiges Verfahren der instrumentellen Analytik. In eine zu untersuchende Probe, die in einem starken, statischen Magnetfeld B₀ angeordnet ist, werden Hochfrequenz(HF-)Pulse eingestrahlt, und die Reaktion der Probe wird vermessen. Aus der Lage und Intensität von NMR-Linien kann auf die chemischen Bindungsverhältnisse in der Probe geschlossen werden.

Das Senden und Empfangen von HF-Strahlung erfolgt dabei mit so genannten HF-Resonatoren. Die HF-Resonatoren sind in unmittelbarer Nähe der Probe angeordnet, oder die Probe ist im Inneren der HF-Resonatoren angeordnet.

Die Qualität einer NMR-Messung ist insbesondre abhängig vom erzielbaren Signal-zu-Rausch-Verhältnis (SNR). Das SNR hängt unter anderem ab von den eingesetzten HF-Resonatoren. Zur Erzielung eines guten SNR sind eine Reihe von Maßnahmen bekannt:
Durch die Verwendung von Torus-Resonatoren [2-5] sind besonders hohe Füllfaktoren erzielbar. Bei Torusresonatoren können jedoch Inhomogenitäten des statischen Magnetfeldes nicht vollständig durch "Shimmen" kompensiert werden. Weiterhin weisen diese Resonatoren ein extrem inhomogenes HF-Feld auf, so dass der hohe Füllfaktor nicht ausgenutzt werden kann.

Weiterhin müssen oft verlustbehaftete Proben vermessen werden; HF-Strahlung wird insbesondere durch Wasser und salzige sowie saure oder basische Lösungen (welche häufig als Lösungsmittel für die Messsubstanz dienen) stark absorbiert. Eine Verbesserung des SNR kann dann durch eine in Richtung des E-Feldanteils der HF-Strahlung dünne Probe, die im Bereich des Nulldurchganges des E-Felds platziert ist, erzielt werden [1].

Aus der [6] ist ein NMR-Tomograph bekannt geworden, bei dem eine HF-Spule mehrere hintereinander aufgereihte, voneinander beabstandete, induktiv gekoppelte, ringförmige Resonatoren aufweist. Die Resonatoren umschließen gemeinsam ein abzubildendes Messvolumen.

Aus [7-11] ist es bekannt, in einem NMR-Messkopf eine Vielzahl von Messproben in jeweils eine separate Detektionsspule einzubringen. Die Proben werden sodann einzeln vermessen. Durch dieses Vorgehen soll die Zeit für das Einbringen von Proben in den Messkopf und für die Feldhomogenisierung minimiert werden. Die Proben enthalten hier in der Regel verschiedene Messubstanzen und sollen separat analysiert werden.

M.A. Macnaughtan et al., Anal. Chem. 2003 (75), 5116-5123 beschreibt einen NMR-Probenkopf mit vier Solenoidspulen, welche elektrisch parallel verschaltet sind. In selektiver Anregung können so vier Proben in schneller Folge vermessen werden. Bei kollektiver Anregung können die vier Proben gemeinsam vermessen werden. Bei der kollektiven Anregung der vier Spulen wird eine Empfindlichkeitsverbesserung um einen Faktor 2 erreicht, verglichen mit der Anregung nur einer der Spulen.

J. Lazovic et al., Magnetic Resonance in Medicine 53 (2005), 1150-1157 beschreibt eine hexagonale Null-Modus Spule zur simultanen Abbildung von sechs kleinen Tieren. Die Spule umfasst sechs ringförmig angeordnete Paare paralleler Platten, die elektrisch parallel verschaltet sind. Bei den Messungen mit der Null-Modus Spule dominieren Spulenverluste.

### Aufgabe der Erfindung

Aufgabe der vorliegenden Erfindung ist es, einem NMR-Messkopf vorzustellen, mit dem bei verlustbehafteten Proben ein verbessertes SNR erreicht werden kann.

### Kurze Beschreibung der Erfindung

Diese Aufgabe wird gelöst durch einen NMR-Messkopf der eingangs genannten Art, der dadurch gekennzeichnet ist, dass die Art der Messsubstanz und die Anzahl N der Grundelemente so ausgewählt sind, dass das Rauschen der Messproben das Gesamtrauschen des NMR-Messkopfs dominiert.

Die Grundidee der vorliegenden Erfindung ist es, mit dem erfindungsgemäßen Messkopf eine simultane Vermessung einer Mehrzahl von gleichartigen Messproben zu ermöglichen. Eine zu vermessende Probe (bzw. eine zur Verfügung stehende Menge an Messsubstanz), die in einem verlustbehafteten Lösungsmittel gelöst ist, wird dazu auf die mehreren Messproben verteilt (Das Lösungsmittel hat HF-Verluste, die entweder auf das Lösungsmittel selbst (insbesondere bei polaren Lösungsmitteln wie Wasser, Methanol, etc...) oder auf eine elektrische Leitfähigkeit (aufgrund gelöste Salze, Säuren oder Basen) zurückzuführen sind). Dadurch können die einzelnen Messproben kleiner dimensioniert und daher besser im Messkopf positioniert werden, insbesondere im Bereich eines E-Feld-Minimums im jeweiligen Resonatorsystem. Die mehreren Messproben werden dann in einem gekoppelten Resonatormode vermessen, wodurch die ursprünglich eine Probe mit einem einzigen Messvorgang (insbesondere einem einzigen Ein- und Auskoppeln) vermessen werden kann. Die N Grundelemente bzw. die zugehörigen N Resonatorsysteme bilden dabei einen Resonatorkomplex, der als ganzes betrieben wird, und insbesondere mit einem gemeinsamen Empfängerschaltkreis ausgelesen wird. Das SNR bei der solchermaßen vermessenen Probe ist deutlich besser als bei Vermessung der Probe, wenn diese unaufgeteilt in einem einzigen Probengefäß in einem einzigen Resonatorsystem angeordnet würde.

Diese Verbesserung kommt dabei folgendermaßen zustande: Wird eine Probe auf N Einzelmessungen mit 1/N der Messsubstanz verteilt und gemeinsam vermessen, so entspricht das N Einzelmessungen mit einer Messprobe (enthaltend 1/N Messsubstanz). Gegenüber der Vermessung einer einzelnen Messprobe (enthaltend 1/N Messubstanz) wird ein SNR-Gewinn von √N erzielt. Im Allgemeinen würde jedoch ein größerer SNR-Gewinn erzielt, wenn die Probe als eine einzige Probe (enthaltend alle Messubstanz) vermessen würde. Im Falle von Proben, bei denen die dielektrischen Verluste das SNR dominieren, gilt dies jedoch nicht: Das SNR bei stark verlustbehafteten zylinderförmigen Proben gleicher Länge und verschiedenen Durchmessern ist stets gleich, da sowohl das Signal als auch das Rauschen proportional zu r² ansteigen. Das heißt, ein mehr an Messsubstanz führt hier nicht zu einer Verbesserung des SNR. In diesem Fall ist dann die Aufteilung der Probe (Messsubstanz) auf N Messproben, wie sie mit dem erfindungsgemäßen NMR-Messkopf vorgesehen ist, wobei die Messproben in einem gekoppelten Mode gemeinsam vermessen werden, in Hinblick auf das SNR überlegen. Wird die Anzahl N Messproben bei konstantem Gesamtvolumen zu stark erhöht, so sinkt das aus den Messproben empfangene Rauschen so weit ab, dass die Bedingung, dass das Rauschen der Messprobe das Gesamtrauschen dominiert, ab einer bestimmten Teilung nicht mehr stimmt und damit das SNR wieder sinkt. Für jede Messsubstanz (bzw. für jedes Lösungsmittel) gibt es eine optimale Teilung Nₒₚₜ, bei der das maximale SNR erreicht wird. Bevorzugt wird im Rahmen der Erfindung daher N gleich Nₒₚₜ gewählt, insbesondere N gleich Nₒₚₜ für H₂O mit 100-200 mMol NaCl.

Im folgenden wird der Aufbau und die Funktionsweise des erfindungsgemäßen NMR-Messkopfs weiter erläutert. Je eine Messprobe und ein zugeordnetes (idR die Messprobe umgebendes oder der Messprobe benachbartes) Resonatorsystem bilden ein Grundelement; die N Grundelemente sind typischerweise untereinander gleich ausgebildet und eng nacheinander aufgereiht (typischerweise in Ringform). Eine jede Messprobe ist bezüglich des ihr zugeordneten Resonatorsystems optimal positioniert (insb. im E-Feld-Minimum und im B₁-Feld-Maximum bzw. im Bereich grösster Homogenität des B₁-Feldes). Durch die Kopplung der N Resonatorsysteme können alle N Messproben gemeinsam und unter gleichen Bedingungen vermessen werden. Es wird insbesondere nur ein einziges, durch alle Grundelemente gemeinsam erzeugtes Messsignal ausgelesen.

Es werden alle N Resonatorsysteme gemeinsam und mit den gleichen Parametern betrieben. Bevorzugt (aber nicht notwendigerweise) sind die Resonatorsysteme so miteinander gekoppelt, dass die Gegeninduktivität eines jeden Resonatorsystems zu seinen benachbarten Resonatorsystemen positiv ist. Die positive Kopplung bedingt dabei, dass lokale B₁-Felder benachbarter Resonatorsysteme im Wesentlichen parallel gerichtet sind. Der erfindungsgemäße NMR-Messkopf ist durch das Kopplungsnetzwerk somit dazu ausgebildet, einen gekoppelten Mode (Torusmode) zu erzeugen, in welchem alle N Resonatorsysteme gemeinsam angekoppelt und gemeinsam durchgestimmt ("getuned") werden können. Das Kopplungsnetzwerk betreibt beim Senden und Empfangen den gleichen, gekoppelten Mode.

### Bevorzugte Ausführungsformen der Erfindung

Besonders bevorzugt ist eine Ausführungsform des erfindungsgemäßen NMR-Messkopfs, bei dem die N Grundelemente ringförmig, insbesondere kreisringförmig, angeordnet sind. Die Messproben befinden sich bevorzugt auf gleichem Radius bezüglich eines Zentrums des Messkopfs. Dies erleichtert die Einstellung eines in jedem Resonatorsystem des Rings gleichen, homogenen B₁-Felds.

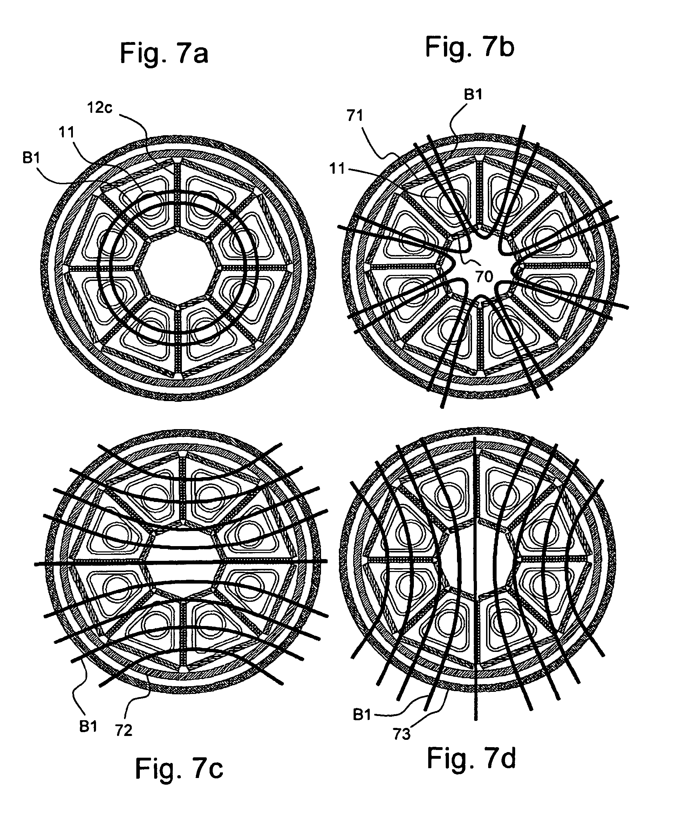

Eine bevorzugte Weiterbildung dieser Ausführungsform ist dadurch gekennzeichnet, dass der NMR-Messkopf dazu ausgebildet ist, einen Torusmode zu erzeugen, bei dem durch alle N Messproben eine gemeinsame, ringförmig geschlossene B₁-Magnetfeldlinie verläuft. Ein entsprechender Messkopf einschließlich B₁-Feld ist in Fig. 7a dargestellt. In dieser Ausführungsform steht besonders viel Raum für Messproben mit einem homogenen B₁-Feld zur Verfügung, so dass besonders gute SNR-Werte erzielbar sind.

Bei einer alternativen Weiterbildung ist der NMR-Messkopf dazu ausgebildet, einen N-Tupol Mode zu erzeugen, bei dem durch je zwei benachbarte Messproben eine gemeinsame, ringförmig geschlossene B₁-Magnetfeldlinie verläuft. Eine entsprechender Messkopf mit B₁-Feldlinien ist in Fig. 7b dargestellt.

Bei einer anderen, vorteilhaften Weiterbildung des erfindungsgemäßen NMR- . Messkopfs ist im Zentrum der ringförmigen Anordnung von Grundelementen eine Lockspule angeordnet. Die Lockspule ist unabhängig von den Resonatorsystemen (des gekoppelten Mode) betreibbar. Durch die separate Lockspule kann eine teuere Deuterierung oder Fluorierung von Lösungsmitteln in den Messproben eingespart werden.

Ganz besonders bevorzugt ist eine Ausführungsform des erfindungsgemäßen NMR-Messkopfs, bei dem die N zylinderförmigen Messproben jeweils eine gleiche Menge der identischen Messsubstanz enthalten. Die zur Verfügung stehende Menge einer zu vermessenden Substanz (Messsubstanz) wird zum Vermessen auf die Messproben (typischerweise gleichmäßig) verteilt (aufgeteilt); jede Messprobe enthält einen Teil der identischen Messsubstanz. Durch die simultane Vermessung der Messproben im NMR-Messkopf wird ein verbessertes Signal-zu-Rausch-Verhältnis (SNR) erreicht.

Bevorzugt ist weiterhin eine Ausführungsform, die vorsieht, dass die N Resonatorsysteme als Sattelspulen ausgebildet sind, insbesondere dass die N Resonatorsysteme als Alderman-Grant-Resonatoren oder als Birdcage-Resonatoren ausgebildet sind. Bei Sattelspulen sind die elektrischen Leiter auf Mantel eines Kreiszylinders angeordnet. Sattelspulen erlauben eine Befüllung mit parallel zum statischen Magnetfeld B₀ stehenden zylinderförmigen Messproben und haben zugleich einen relativ hohen Füllfaktor, da alle Leiter in unmittelbarer Nähe der Messprobe angeordnet werden können.

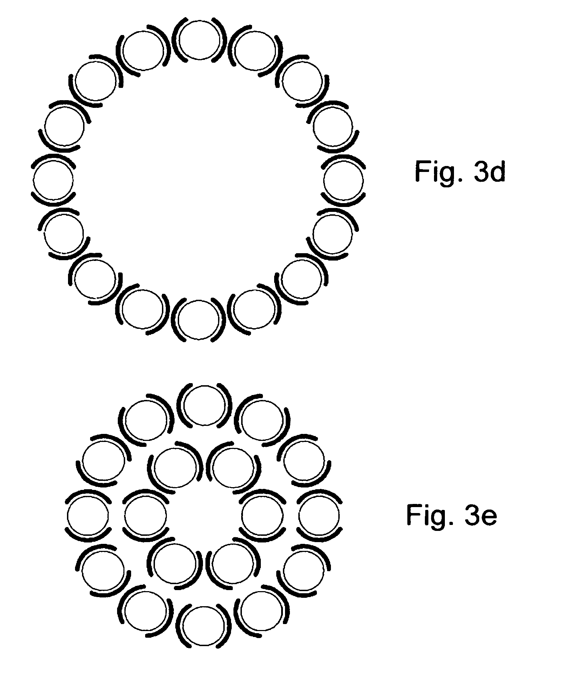

Bei einer bevorzugten Weiterbildung dieser Ausführungsform weist der NMR-Messkopf eine kreisringförmige Anordnung von Sattelspulen auf, wobei jeweils eine Messprobe im Inneren einer jeden Sattelspule angeordnet ist, und die Leiterfenster einer jeden Sattelspule jeweils ihren beiden benachbarten Sattelspulen zugewandt sind. Diese Anordnung gestattet die Ausbildung eines Torusmode mit einer ringförmig geschlossenen B₁-Feldlinien durch alle Messproben. Ein entsprechender NMR-Messkopf ist in Fig. 3d dargestellt.

Bei einer anderen Ausführungsform des erfindungsgemäßen NMR-Messkopfs sind die N Resonatorsysteme als planare Helmholz-Spulen oder als planare Resonatoren ausgebildet sind. Bei dieser Ausführungsform sind die elektrischen Leiter auf (einem oder auch zwei) ebenen Plättchen angeordnet. Dies ist besonders einfach zu fertigen und besonders stabil. Diese Ausführungsform ist insbesondere bei der Verwendung von Hochtemperatur-Supraleiter-Materialien (HTS) bevorzugt, da HTS mit guten Materialparametern derzeit nur auf bestimmten planaren Substraten hergestellt werden kann. Die planare Ausführung vereinfacht weiterhin die Bearbeitung mittels lithographischer Techniken, bei denen ein Grossteil der Prozesse mit hoher Präzision nur für planare Trägermaterialien zur Verfügung stehen. Dies gilt insbesondere für das Belacken, Kontaktlithographie und lonenätzen.

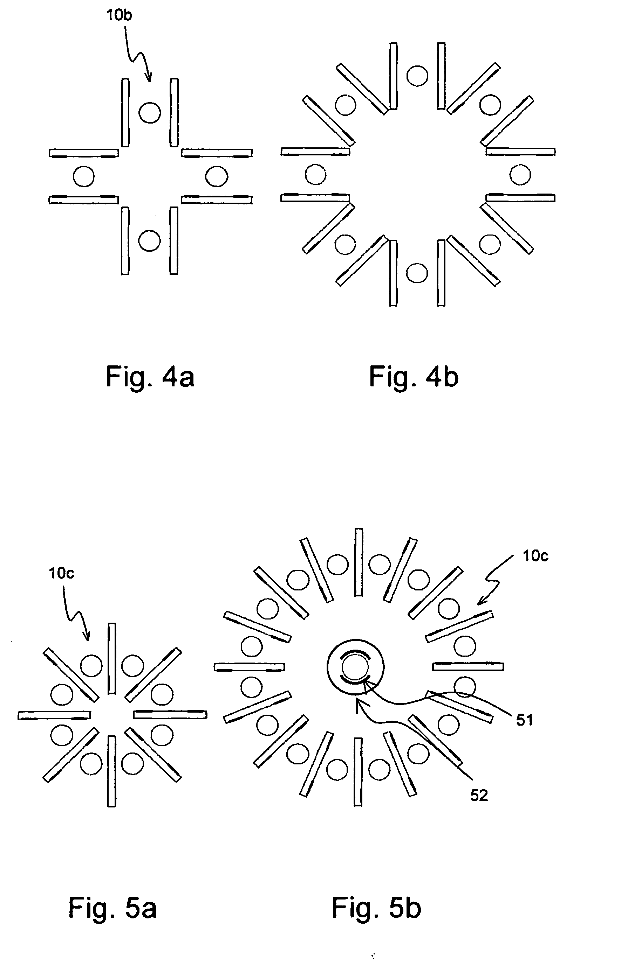

Bei einer bevorzugten Weiterbildung dieser Ausführungsform umfasst der NMR-Messkopf eine kreisringförmige Anordnung von planaren Helmholz-Spulen, wobei jeweils eine Messprobe im Inneren einer planaren Helmholz-Spule angeordnet ist, und die planaren Helmholz-Spulen mit ihren ebenen Substratplättchen radial ausgerichtet sind. Bevorzugt beträgt hierbei N≥8. Ein entsprechender NMR-Messkopf ist in Fig. 4b abgebildet. Damit kann auf einfache Weise ein Torusmode mit guter Homogenität erzeugt werden.

Bei einer alternativen Weiterbildung der obigen Ausführungsform umfasst der NMR-Messkopf eine kreisringförmige Anordnung von planaren Resonatoren, wobei jeweils zwischen zwei aufeinander folgenden planaren Resonatoren eine Messprobe angeordnet ist, und wobei die planaren Resonatoren jeweils radial ausgerichtet sind. Bevorzugt beträgt hierbei wiederum N ≥ 8. Ein entsprechender NMR-Messkopf ist in Fig. 5a oder auch Fig. 5b dargestellt. Damit kann auf einfache Weise ein Torusmode mit guter Befüllung erzeugt werden.

Bei einer weiteren, vorteilhaften Weiterbildung weisen die N Resonatorsysteme Leiterbahnen aus Hochtemperatur-Supraleiter auf. Dadurch kann eine höhere elektrische Güte, d.h. weniger Rauschanteil aus dem Resonatorsystem, und damit besseres SNR erreicht werden.

Bevorzugt ist auch eine Ausführungsform, bei der für die Anzahl N der Grundelemente gilt: N ≥ 6, bevorzugt N ≥ 8, und besonders bevorzugt N ≥ 12. Mit mehr Grundelementen lässt sich in der Regel eine bessere Befüllung des gekoppelten Mode erreichen.

Vorteilhaft ist auch eine Ausführungsform eines erfindungsgemäßen NMR-Messkopfs, wobei der Messkopf mindestens einen zusätzlichen Resonatorkomplex für eine weitere Messfrequenz aufweist, insbesondere wobei der zusätzliche Resonatorkomplex als Sattelspule ausgebildet ist, in deren Innerem die N Grundelemente angeordnet sind. Mit dem zusätzlichen Resonatorkomplex und dessen weiterer Messfrequenz (die erste Messfrequenz gehört zum gekoppelten Mode) wird der Messkopf zum Mulit-Resonanz-Messkopf, mit dem mehrere Kerne in orthogonalen Moden gleichzeitig vermessen werden können. Besonders bevorzugt ist eine Kombination aus vier, fünf oder sechs der folgenden Kerne: ¹H, ²H, ¹³C, ¹⁵N, ¹⁹F, ²⁹Si, ³¹P.

Weitere Vorteile der Erfindung ergeben sich aus der Beschreibung und den Zeichnungen. Ebenso können die vorstehend genannten und die weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Zeichnung und detaillierte Beschreibung der Erfindung

Die Erfindung ist in der Zeichnung dargestellt und wird anhand von Ausführungsbeispielen näher erläutert. Es zeigen:
- Fig.1a-1c: schematische Darstellungen von Grundelementen mit Messprobe und Resonatorsystem der Typen Sattelspule a), planare Helmholzspule b), und planarer Resonator c), für erfindungsgemäße NMR-Messköpfe;
- Fig. 2a: eine schematische Darstellung einer Kombination von zwei Grundelementen des Typs planare Helmholzspule;
- Fig. 2b: eine schematische Darstellung einer Kombination von zwei Grundelementen des Typs planarer Resonator und eines Grundelements des Typs planare Helmholzspule;
- Fig. 3a-3d: schematische Darstellungen von erfindungsgemäßen NMR-Messköpfen mit ringförmig angeordneten Grundelementen vom Typ Sattelspule;
- Fig. 3e: eine schematische Darstellung eines erfindungsgemäßen NMR-Messkopfs mit zwei ineinander geschachtelten Ringen von Grundelementen vom Typ Sattelspule;
- Fig. 4a-4b: schematische Darstellungen von erfindungsgemäßen NMR-Messköpfen mit ringförmig angeordneten Grundelementen vom Typ planare Helmholzspule;
- Fig. 5a-5b: schematische Darstellungen von erfindungsgemäßen NMR-Messköpfen mit ringförmig angeordneten Grundelementen vom Typ planare Resonatoren;
- Fig. 6a: eine schematische Darstellung eines Feldprofils eines isolierten Grundelements vom Typ planare Helmholzspule;
- Fig. 6b: eine schematische Darstellung eines Feldprofils eines Grundelements vom Typ planare Helmholzspule innerhalb des NMR-Messkopfs von Fig. 4b;
- Fig. 7a-7d: schematische Darstellungen von B₁-Feldlinien von verschiedenen, orthogonalen Moden eines erfindungsgemäßen NMR-Messkopfs, der mehrere Resonatorkomplexe für die verschiedenen Moden und zugehörigen Resonanzfrequenzen aufweist;
- Fig. 8a-8b: schematische Darstellungen von Spulengeometrien in einem erfindungsgemäßen NMR-Messkopf;
- Fig. 9a: eine schematische Darstellung des radialen Feldprofils im Zentrum eines Hohlraumresonators gemäß [4];
- Fig. 9b: eine schematische Darstellung des radialen Feldprofils im Zentrum eines des Resonatorkomplexes gemäß Fig. 4b.

Die Darstellungen der Grundelemente und Messkopfe zeigen jeweils Querschnittsansichten.

Die Erfindung betrifft einen Kernspinresonanz(NMR)-Messkopf, insbesondere mit einer Torusspule oder eines Torusresonators, zur Erzielung eines besseren Signal-zu-Rausch-Verhältnisses bei NMR-Messungen von verlustbehafteten Proben, insbesondere in der hochauflösenden NMR-Spektroskopie.

### Hintergrund

Ein "Problem" der hochauflösenden NMR stellt die Verwendung flüssiger Messproben dar. Diese müssen in Probenröhrchen abgefüllt werden, die wiederum senkrecht (in Bezug auf die Gravitationskraft) in die Messapparatur eingebracht werden müssen. Da die Rahmenbedingungen der Herstellung (supraleitender) Hochfeldmagnete dazu führen, dass es technisch sehr aufwändig und daher deutlich teurer ist, eine Bohrung quer zum statischen Magnetfeld zu erzeugen, wird in der Regel die Messprobe parallel zum statischen Magnetfeld (das die z-Richtung definiert) eingeführt und als Spule anstelle einer effizienteren Solenoidspule eine Sattelspule verwendet. Aufgrund der mechanischen Anordnung werden Solenoidspulen in der hochauflösenden NMR fast ausschliesslich im Durchflussbetrieb eingesetzt, bei dem die Messsubstanz durch eine Kapillare in die permanent (horizontal) montierte Flusszelle gedrückt wird (siehe z.B. [10]).

Eine Solenoidspule ist ca. doppelt so effizient wie eine Sattelspule, ein Torus ist fast einen Faktor fünf effizienter. Der Vorzug eines idealen Torus ist, dass sich die gesamte magnetische Feldenergie im Inneren des Resonators und damit im Messvolumen befindet. Der Füllfaktor ist hiermit 1. Bei einer Solenoidspule erreicht man je nach Länge einen Füllfaktor von ca. 0.4-0.5, bei einer Sattelspule in der Regel unter 0.2. Aus [2-5] sind torusförmige HohlraumResonatoren für die NMR-Messungen in Druckzellen oder zum Imaging bekannt.

Eine Anforderung der hochauflösenden NMR ist es, das statische Feld B₀ so homogen einzustellen, dass die Linienverbreiterungen aufgrund von Inhomogenitäten kleiner ausfallen als die natürlichen Linienbreiten. Da diese in der Grössenordnung von unter einem Herz liegen können, muss die Homogenität des statischen Feldes besser als 10⁻⁹ sein. Den Vorgang des Einstellens der Homogenität mittels Kompensationsspulen nennt man "Shimen".

Die Anforderungen an die Feldhomogenität sind so hoch, dass selbst der geringe Para- oder Diamagnetismus von "nichtmagnetischen" Substanzen wie Lösungsmitteln, Glas, aber auch Kupfer oder Aluminium zu Feldstörungen führt, die kompensiert werden müssen. Dies kann zum Teil dadurch gelöst werden, dass Materialien mit einer magnetischen Suszeptibilität von null verwendet werden. Wenn die Suszeptibilität nicht auf null kompensiert werden kann, wie z.B. bei der Messprobe, dann muss das Demagnetisierungsfeld mittels Kompensationspulen "geshimt" werden. Dies kann allerdings nur für verallgemeinerte Ellipsoide gelingen, d.h. wenn die Messprobe entweder eine Kugel, ein Ellipsoid, ein unendlich langer Zylinder oder eine unendlich lange, beliebig dünne Ebene ist. Unendlich lang bedeutet in diesem Zusammenhang deutlich länger als das HF-Profil der Detektionsspule.

Für die Sattelspule ist die Messprobe ein Zylinder, der in der z-Richtung "unendlich lang" ist, für die Solenoidspule in der x-Richtung (wobei x die Richtung die Richtung des HF-Feldes ist).

Das Problem eines Torusresonators ist es jedoch, dass die Messprobe auch torusförmig ist und daher in keiner Richtung länger sein kann als das HF-Feld. Somit können die Inhomogenitäten des statischen Feldes, die durch das Demagnetisierungsfeld entstehen, nicht kompensiert werden. Aus [3] ist bekannt, wie die Störungen am äusseren Ende eines toroidförmigen HohlraumResonators beherrscht werden können, auch wenn die Suszeptibilität des Resonatormaterials nicht kompensiert ist. Die Anleitung, die [3] zur Korrektur der Störungen an den Enden der Messprobe gibt, ist es einen Teil des (aktiven) Volumens der Messprobe durch suszeptibilitätsangepasste Verdränger zu eliminieren, d.h. den Resonator nur partiell zu befüllen. Auf diese Weise werden eventuelle Vorteile der Hohlraumresonatoren bezüglich des Signal zu Rauschverhältnisses dramatisch reduziert. Darüber hinaus muss der Hohlraumresonator von [3] zum Wechseln der Messprobe demontiert werden, es sei denn er wird im Durchflussbetrieb mittels Ein- und Auslasskapillaren betrieben.

Ein weiteres Problem von Sattel und Solenoidspulen entsteht, wenn die Messproben verlustbehaftet sind. Die HF-Verluste der Messprobe resultieren in einer elektrischen Leitfähigkeit σ (z.B. durch gelöste Salze, Säuren oder Basen) der Messproben oder in dielektrischen Verlusten tan δ des Lösungsmittels (z.B. durch Anregung von Rotations- oder Vibrationsbanden der Moleküle). Die dielektrischen Verluste sind insbesondere bei polaren Lösungsmitteln sehr hoch und steigen mit der vierten Potenz der Frequenz im relevanten Frequenzbereich 100 MHz - 1 GHz.

Ein Lösungsansatz dieses Problems wird in [1] offenbart, bei dem die Länge a der Messprobe in Bezug auf die x-Richtung, d.h. die Richtung des HF-Feldes, vergrössert wird und die Breite b (d.h. die y-Richtung) verringert wird. Ein ideales Resonatorsystem weist eine magnetische Symmetrie in Bezug auf die xz-Ebene auf, so dass das elektrische Feld in dieser Ebene identisch 0 ist. Es steigt weitestgehend linear in y-Richtung an (wobei E(y) = -E(-y)), so dass die Verluste (∼σ E²) quadratisch ansteigen. Im Grenzfall, dass die Verluste der Messprobe die Gesamtverluste dominieren, führt dies zu einer Erhöhung des Signal zu Rauschverhältnisses um einen Faktor √(a/b) in Bezug auf eine kreiszylinderförmige Messprobe.

Aus [7-11] ist bekannt, dass ein NMR-Messkopf gebaut werden kann, bei dem eine Vielzahl von Messproben jeweils in eine separate Detektionsspule eingebracht werden. Das Ziel ist es hierbei, die verlorene Zeit zum Einbringen einer Messprobe in den Probenkopf zu reduzieren, indem mehrere Messproben zur gleichen Zeit eingebracht werden. Diese Zeit beinhaltet sowohl das Einbringen, sowie das zugehörige Shimen (Feldhomogenisierung), Locken (Feldstabilisierung) und Temperieren.

Die hier nachfolgend beschriebene Erfindung zeigt einen Weg auf, wie in der hochauflösenden NMR das Signal zu Rauschverhältnis insbesondere für verlustbehaftete Messproben drastisch erhöht werden kann, indem die Messsubstanz auf multiple Messproben verteilt wird.

### Vorstellung der Erfindung

Analog zur Sattelspule kann eine Torusspule oder ein Torusresonator so ausgelegt werden, dass in der z-Richtung oben und unten Öffnungen für das Einbringen der Messproben in der z-Richtung bleiben:

Eine Anzahl N von Messproben werden hierbei ringförmig angeordnet und z.B. mit HTS-Resonatoren wird ein ringförmiges *B*₁-Feld angeregt. Bei einem kryogen gekühlten Messkopf muss jede Messprobe temperiert werden. Dies kann entweder einzeln oder durch ein gemeinsames Zentralrohr geschehen.

Wird eine Messsubstanz auf N Messproben verteilt und mit N nicht gekoppelten Resonatorsystemen gemessen, so entspricht dies N Einzelmessungen mit einer einzigen Messprobe. Daher wird ein Gewinn in Signal zu Rauschen von √ N erreicht in Bezug auf eine Einzelmessprobe erreicht werden. In der Regel ist dies deutlich niedriger als wenn die gesamte Substanzmenge in einer Messprobe gemessen würde, da das Rauschen aus N Resonatoren höher ist als das Rauschen eines einzigen grossen Resonators.

Es gibt jedoch Situationen, in denen eine deutliche Steigerung der Leistungsfähigkeit erzielt werden kann, wenn die Messsubstanz auf kleinere Messproben verteilt wird. Dies ist insbesondere der Fall, wenn die Messproben verlustbehaftet sind. Für den Fall, dass die Verluste der Messproben die Gesamtverluste dominieren, erreicht man bei gleicher Länge in z-Richtung exakt dasselbe Signal zu Rauschverhältnis mit zylinderförmigen Messproben beliebigen Durchmessers. In dieser Situation kann eine Steigerung des Signal zu Rauschverhältnisses um √N erreicht werden.

Anders betrachtet kann ein Verhältnis Länge zu Breite von N erreicht werden, als ob man der Referenz [1] folgend eine rechteckförmige Messprobe mit Länge a = N * b verwenden würde.

Darüber hinaus ist es in der Regel möglich, das Verhältnis von aktivem zu passivem Volumen zu verbessern, wenn die Messproben kleiner werden. Dies liegt daran, dass die Flankensteilheit des HF-Feldes grösser ist, je kleiner der Spulendurchmesser ausfällt. Mit steilerer Flanke kann aber auch das passive Volumen reduziert werden, das lediglich dazu dient, die Shimbarkeit des befüllten Messkopfes zu garantieren. Weiterhin fällt die magnetische Störung am Ende der Messprobe aufgrund der geringeren Masse absolut kleiner aus, so dass dieses Ende näher an die Flanke des HF-Feldes gezogen werden kann.

Der erfindungsgemäße Messkopf umfasst N Grundelemente, wobei ein Grundelement jeweils eine Messprobe (bzw. eine Messprobenposition) und ein (ggf. mehrteiliges) Resonatorsystem aufweist. Ein Grundelement bzw. das zugehörige Resonatorsystem kann folgendermassen gestaltet sein: a) Sattelspule, b) planare Helmholzspule, c) planarer Resonator. Andere Varianten von Resonatorsystemen (bzw. Spulensystemen) sind ebenfalls möglich.

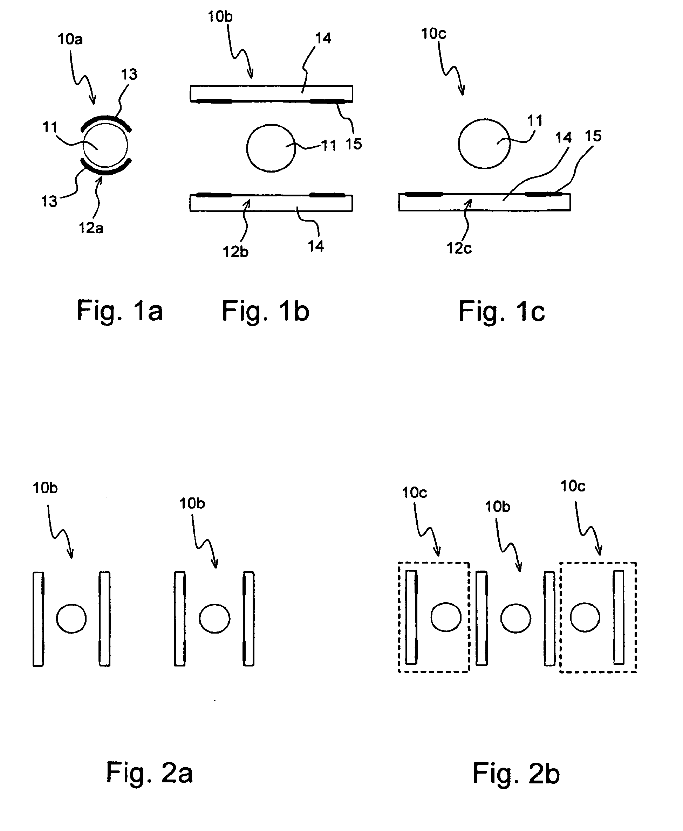

Die Figuren 1a, 1b, 1c zeigen jeweils im Querschnitt ein Grundelement 10a, 10b, 10c, mit je einer (hier runden) Messprobe 11 und je einem Resonatorsystem 12a (Sattelspule mit dick eingezeichneten, oben und unten liegenden Leiterfenstern 13), 12b (planare Helmholzspule, umfassend zwei gegenüberliegende Plättchen 14 mit Leitern 15), 12c (planarer Resonator, umfassend ein Plättchen 14 und Leiter 15).

Werden nun mehrere Resonatorsysteme zu einem gemeinsamen Mode gekoppelt, so besteht die Möglichkeit, noch über die √N der ungekoppelten Grundelemente hinaus zu gewinnen, da der Anteil der magnetischen Energie im Messvolumen im Verhältnis zur Gesamtenergie erhöht werden kann. Es gibt allerdings auch Situationen, in denen durch die Kopplung der Füllfaktor verschlechtert wird. Dies ist dann der Fall, wenn durch die Kopplung Volumenelemente mit hoher Feldstärke generiert werden, die nicht mit Messsubstanz bestückt werden. Ein offensichtliches Beispiel hierfür ist eine Kombination aus zwei Grundelementen b), bei denen der Abstand der Grundelemente ungefähr gleich gross ist wie der Abstand zwischen den beiden planaren Resonatoren, vgl. **Figur 2a** mit den beiden beabstandeten Grundelementen 10b. In diesem Fall ist das gekoppelte System nur zu ca. 2/3 befüllt, da es eigentlich einer Kombination von zwei Grundelementen des Typs c) und einem Grundelement vom Typ b) mit insgesamt drei Messproben entspricht, vgl. **Fig. 2b** mit den Grundelementen 10c außen (gestrichelt umschlossen) und dem Grundelement 10b innen.

Um einen möglichst hohen Füllfaktor zu erzielen, ist es daher unumgänglich, eine Kombination von Resonatoren zu wählen, die eine möglichst hohe Befüllung mit Messproben erlaubt. Weiterhin kann es wünschenswert sein, die Form der Messproben anzupassen und diese z.B. rechteckförmig oder als Torussegmente zu wählen. Zusätzlich besteht auch die Möglichkeit, gängige Methoden zur Verlängerung der Messproben ausserhalb des aktiven Bereiches des Resonators mittels suszeptibilitätsangepasster Verdränger einzusetzen um das verlorene Probenvolumen weiter zu verringern.

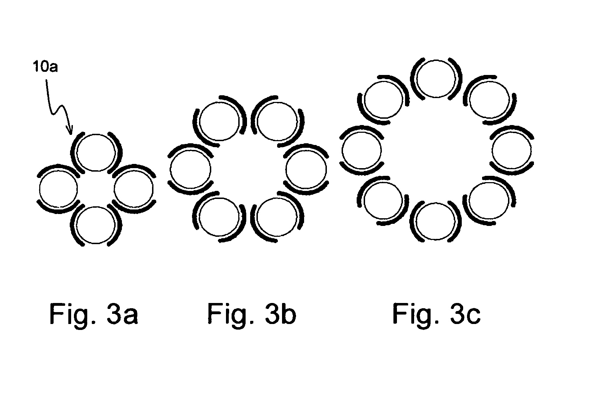

Die **Figuren 3a bis 3e** zeigen als NMR-Messköpfe einige mögliche Kombinationenen aus Grundelementen a), wobei entweder vier (Fig. 3a), sechs (Fig. 3b), acht (Fig. 3c) oder sechzehn (Fig. 3d) Resonatorsystemen (Sattelspulen) zu einem Torus kombiniert werden, oder zwei Tori mit sechs und zwölf Grundelementen ineinander verschachtelt sind (Fig. 3e). Die Leiterfenster benachbarter Grundelemente 10a der Tori sind in den gezeigten Beispielen jeweils einander zugewandt. Eine gerade Anzahl N von Elementen kann das Shimen vereinfachen. Eine ungerade Anzahl N von Elementen kann eine Ortsauflösung mittels Gradientencodierung vereinfachen.

Das zweite und dritte Grundelement, d.h. die Typen b) und c), sind insbesondere bei cryogen gekühlten Messköpfen mit Resonatorsystemen aus Hochtemperatursupraleiter relevant. Bei einem solchen Messkopf muss die Messprobe thermisch vom Resonatorsystem entkoppelt werden. Dadurch wird der Füllfaktor der Resonatorsysteme zwar verschlechtert, durch den Gewinn an Widerstand und Temperatur wird dies aber mehr als wettgemacht.

Kombinationen für Messköpfe aus dem zweiten Grundelement, d.h. Typ b),sind in den **Figuren 4a** und **4b** dargestellt. Die gezeigten Beispiele umfassen jeweils vier (Fig. 4a) und acht (Fig. 4b) Grundelemente 10b.

Es ist offensichtlich, dass insbesondere für eine geringe Anzahl von Grundelementen diese Kombination suboptimal ist, da die Befüllung des Torusmodes mit Messproben sehr schlecht ist. Z.B. in Fig. 4a werden vier sehr grosse Bereiche zwischen den Grundelementen 10b, nämlich links oben, rechts oben, links unten und rechts unten, generiert, in denen zwar hohes HF-Feld erzeugt wird, aber keine Messprobe positioniert wurde. Je grösser die Anzahl der Grundelemente, desto geringer wird der Anteil dieser ungenutzten Bereiche jedoch. Vorteilhaft bei der Anordnung von Grundelementen des Typs b) ist die hohe Homogenität des HF-Feldes, die im Bereich der Messprobe erreicht wird. Weiterhin ist die Konstruktion eines solchen Messkopfes einfacher.

Effizientere Anordnungen von planaren Resonatorsystemen, entsprechend Typ c), für einen Messkopf sind in den **Figuren 5a und 5b** für acht (Fig. 5a) und sechzehn (Fig. 5b) Grundelemente 10c bzw. Messproben gezeigt.

Ein erfindungsgemässer Messkopf hat mehrere Vorteile:
1. Die Effizienz erhöht sich dramatisch. Ein komplett gefüllter, perfekter Torus hat einen (maximal möglichen) Füllfaktor η von 1. Zum Vergleich ist der Füllfaktor beim Solenoiden ca. 0.5 und bei der Sattelspule/Birdcage ca. 0.2. Hier ist ein Verbesserungspotential von einem Faktor fünf in Bezug auf die gängigen Spulenkonfigurationen in der NMR. Ein erfindungsgemässer Resonatorkomplex, der im Torusmode betrieben wird, kann zwar nicht vollständig gefüllt werden. Bei Verwendung von ausreichend Grundelementen kann dennoch eine Verbesserung des Füllfaktors um einen Faktor zwei erreicht werden. Durch die Verwendung von nicht kreiszylinderförmigen Messproben z.B. mit quadratischem oder rechteckigem Querschnitt kann der Füllfaktor eines erfindungsgemässen Messkopfes weiter gesteigert werden.
2. Abschirmungen in z-Richtung erübrigen sich, da kein (oder kaum) Feld im Aussenraum erzeugt wird. Normalerweise sind solche Abschirmungen notwendig, um das Hochfrequenzfeld auf ein gewünschtes Volumen zu begrenzen. Sind solche Abschirmungen nicht vorhanden, sind Experimente mit Lösungsmittelunterdrückung sowie das Erreichen natürlicher Linienbreiten nur schwer möglich.

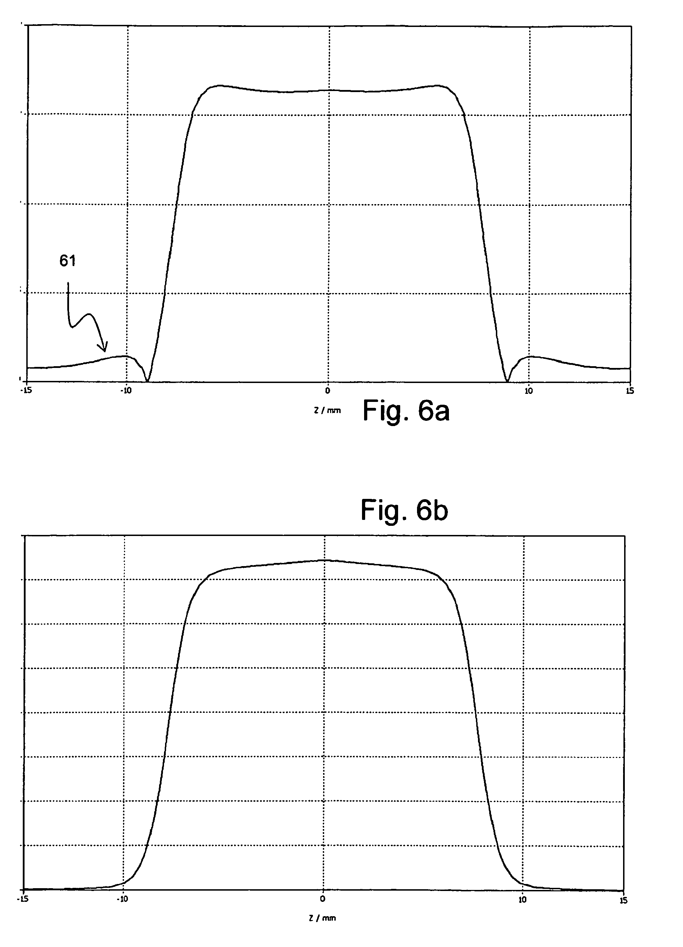

   In **Fig. 6a** ist der Absolutwert des NMR-aktiven HF-Feldes entlang der Zylinderachse der Messproben für ein typisches Grundelement vom Typ b) dargestellt. Man erkennt, dass im Aussenbereich ein Rückfluss 61 des Feldes zu einer ineffizienten Verlängerung des Messbereiches führt. Soll ein solcher Messkopf eingesetzt werden, müssen diese Aussenbereiche abgeschirmt werden. Dies führt zu zusätzlichen Verlusten in Güte und Effizienz und kompliziert den Aufbau.
   In **Fig. 6b** ist das Feldprofil für einen Messkopf gemäss Fig. 4b mit sechzehn Grundelementen vom Typ c) gezeigt. Es ist klar ersichtlich, dass das Feld ohne zusätzliche Abschirmungen auf das gewünschte, "aktive" Volumen begrenzt ist. Dies erhöht auch den Füllfaktor und damit das erreichbare Signal zu Rauschverhältnis. Weiterhin können eventuelle Abschirmungen so platziert werden, dass das elektrische und/oder magnetische Feld zusätzlicher Resonatoren bestimmte Anforderungen erfüllt. Wird der Messkopf mit mehr als einem Resonatorkomplex betrieben, besteht zumindest für einen zweiten Resonatorkomplex die freie Wahl der Positionierung der Abschirmung. Diese kann z.B. so gewählt werden, dass die B₁-Profile des Torusmodes und des zweiten Resonatorkomplexes möglichst ähnlich sind oder dass lediglich die Feldeigenschaften des zusätzlichen Resonatorkomplexes optimiert werden.
3. Die HF-Verluste in verlustbehafteten Messproben entsprechen ungefähr dem N-fachen der Verluste einer Messprobe mit geringem Durchmesser. Mit 16 Messproben wird ein "Längen-zu-Breiten"-Verhältnis von über 16:1 und das Potential für eine vierfache SNR-Steigerung in Bezug auf dasselbe Volumen in einem einzigen runden Sample generiert, zumindest dann wenn die Verluste in der Messprobe das Signal zu Rauschen dominieren.
4. Durch die Verwendung des Torusmodes für die Detektionsfrequenz (in der Regel Protonen oder Fluor) stehen nicht nur die linearen, sondern auch der N-tupol Mode unabhängig zur Verfügung. Dadurch können bei einem Triple-Resonanz-Probenkopf vier völlig unabhängige Resonatorkomplexe betrieben werden und alle Kerne einzeln abgestimmt werden. In **Fig. 7a** ist der Protonenmode (ein Torusmode) eines Triple-Resonanz-Probenkopfes dargestellt (erzeugt durch radial ausgerichtete planare Resonatoren 12c; das B₁-Feld verläuft mit einigen Feldlinien ringförmig geschlossen durch alle Messproben 11), in **Fig. 7b** der zugehörige ¹³C Mode als Oktupolmode (erzeugt durch senkrecht zum Radius ausgerichtete, innere und äußere Resonatoren 70, 71; einige B₁-Feldlinien durchlaufen jeweils gemeinsam benachbarte Messproben 11). In den beiden **Figuren 7c und 7d** sind die beiden weiteren orthogonalen Moden, die z.B. für ¹⁵N und ²H eingesetzt werden können, gezeigt (erzeugt jeweils durch äußere, ringförmige Resonatoren 72 und 73, auch genannt lineare Spulen).

Die Durchmesser der linearen Spulen werden zwar deutlich grösser als bei einem konventionellen Messkopf mit zwei Detektionsspulen und einer einzigen Messprobe, die Effizienz nimmt aber zu, da jeweils nur eine einzige Messfrequenz auf einer Spule abgestimmt werden muss. Für die zusätzlichen linearen Spulen werden am sinnvollsten Birdcages oder Alderman-Grant Resonatoren verwendet. Weiterhin kann mittels Netzwerk auf den linearen Spulen jeweils noch ein Kern eingekoppelt werden, so dass ein Penta-Resonanz-Probenkopf entsteht.

Durch die Orthogonalität der Moden kann auch ein Messkopf gebaut werden, bei dem die Torus- und die Oktupolspule (bzw. deren einzelne Resonatoren 12c, 70, 71) jeweils aus HTS aufgebaut sind, die linearen Spulen 72, 73 jedoch normalleitend. Die zu erwartenden Kopplungen durch Imperfektionen sind so gering, so dass eine Dämpfung der HTS-Resonatorsysteme nicht zu befürchten ist.

In der hochauflösenden NMR, insbesondere der Hochfeld NMR mit Protonenfrequenzen zwischen 400 MHz und 1 GHz werden standardmässig Messproben mit 5 mm Aussendurchmesser verwendet und zwischen 40 und 60 mm hoch befüllt. Bedingt durch die Wandstärke der Probenröhrchen und die Füllhöhe liegt damit das Probenvolumen im Bereich von ca. 550-900 µl. Aus untenstehender Tabelle kann entnommen werden, wie viele Messproben benötigt werden, um 600 µl Messsubstanz in die entsprechenden Messproben zu füllen (AD: Außendurchmesser; ID: Innendurchmesser).

| AD | ID | Füllhöhe | Volumen | # | Kommentar |
|---|---|---|---|---|---|
| in mm | in mm | in mm | in µl | Sample | |
| 1 | 0.8 | 25 | 12.5 | 48 | |
| 1.7 | 1.3 | 28 | 37 | 16 | |
| 1.9 | 1.5 | 34 | 60 | 10 | |
| 2 | 1.6 | 38 | 75 | 8 | |
| 2.5 | 2.2 | 40 | 150 | 4 | |
| 3 | 2.42 | 40 | 185 | 3 | |
| 4 | 3.24 | 40 | 330 | 2 | |
| 5 | 4.24 | 40 | 565 | 1 | dünnwandig |
| 5 | 4.52 | 40 | 640 | 1 | ultra dünnwandig |

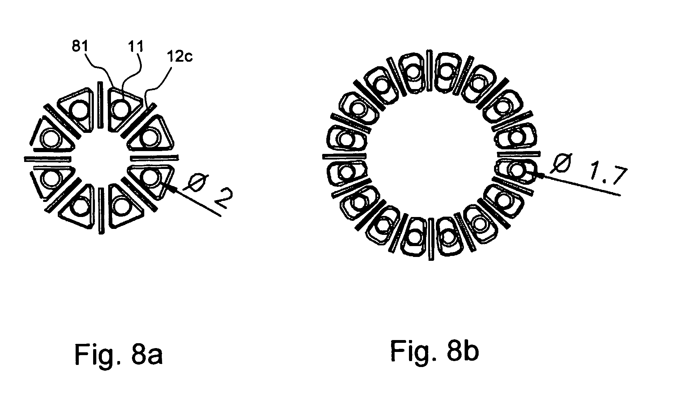

Ein Messkopf mit acht 2 mm, sechzehn 1.7 mm oder achtundvierzig 1 mm Messproben hätte ungefähr dasselbe Probenvolumen wie ein konventioneller Messkopf für 5 mm Messproben. Die Spulengeometrie sowie ein Zentralrohr je Messprobe zwecks thermischer Isolation ist in den **Figuren 8a und 8b** für die Fälle der 2 mm (Fig. 8a) und 1.7 mm (Fig. 8b) Messproben dargestellt, mit Messproben 11, Zentralrohren 81 und planaren Resonatoren 12c. Das Zentralrohr muss nicht zwangsläufig den freien Raum voll ausnutzen, sondern kann auch kreiszylinderförmig ausgeführt sein wie die Messproben. Es ist jedoch sinnvoll, dass das Zentralrohr in seiner Form jeweils an den zur Verfügung stehenden Platz angepasst wird. Das Zentralrohr dient zur thermischen Isolation zwischen warmer Messprobe und kalter Detektionsspule: Innerhalb des Zentralrohres herrschen Temperaturen um die 300 K (nahe bei Raumtemperatur), die planaren Resonatorsysteme sind auf cryogene Temperaturen unter 80 K, besser unter 25 K gekühlt. Alternativ können auch alle warmen Bereiche miteinander verbunden werden. Dies kann die Konstruktion und/oder das Temperieren der Messproben vereinfachen.

Steht nicht ausreichend Messsubstanz zur Verfügung, so kann ein derartiger Messkopf auch nur partiell befüllt werden. Hierbei wird zwar Füllfaktor verloren, die Versatilität des Messkopfes wird jedoch in Bezug auf einen Konventionellen Messkopf deutlich gesteigert. In einem Messkopf für 5 mm Probenröhrchen muss bei fehlender Messsubstanz entweder die Messprobe verdünnt werden oder der Durchmesser der Messproben verringert werden. Bei der Verwendung verschiedener Durchmesser müssen nicht nur verschiedene Probenröhrchen, sondern auch die zugehörigen Halter etc. angeschafft werden, was die Auswahl an verwendbaren Volumina in der Regel auf zwei, maximal drei begrenzt. Bei extremen Verdünnung können weiterhin Probleme mit der Reinheit der Lösungsmittel in Bezug auf die Konzentration der Messsubstanz auftreten.

Bei einer ringförmigen Anordnung der Grundelemente bleibt in deren Zentrum freier Raum. Dieser kann dazu genutzt werden, um eine separate Lockspule einzubringen ("externer Lock"), vgl. dazu beispielhaft **Fig. 5b**, mit Grundelementen 10c und Lockspule 51. Um eine Kopplung zwischen der Lockspule und den umgebenden Resonatorkomplexen zu vermeiden, kann die Lockspule mittels einer Abschirmung 52 abgeschirmt werden.
In der Regel wird in der hochauflösenden NMR das Lösungsmittel teilweise oder vollständig deuteriert oder fluoriert und mittels eines Sende- und Empfangssystems das NMR-Signal des Lösungsmittels verfolgt. Dieses Signal enthält sowohl Informationen über die Stärke des statischen Magnetfeldes B₀ als auch über dessen Homogenität.
Mittels einer Regelungsautomatik werden Kompensationsspulen so angesteuert, dass die Anforderungen an die Feldstabilität sowie die Feldhomogenität eingehalten werden.

Eine separate Lockspule hat den Vorzug, dass das Lösungsmittel der Messproben nicht mehr deuteriert/fluoriert werden muss. Dies führt für den Anwender zu grossen finanziellen Einsparungen, da diese Lösungsmittel sehr teuer sind und bei dieser Ausführungsform bei allen Messungen mit ein und derselben Messprobe gelockt werden kann.

Zusätzlich gibt es wichtige NMR Experimente, z.B. bei Proteinanalysen, bei denen das SNR erhöht werden kann, wenn keine deuterierten Lösungsmittel verwendet werden. Dies gilt insbesondere für alle Amidprotonen detektierte Experimente (wie z.B. HSQC), die zu den wichtigsten bei der Strukturanalyse von Proteinen gehören. Da die Amidprotonen mit den Protonen des umgebenden Lösungsmittels, in der Regel H₂O/D₂O, austauschen, werden sie der D₂O Konzentration entsprechend reduziert. Dies kann zu einer Steigerung des SNR um 11 % führen, wenn statt 90% H₂O / 10% D₂O reines H₂O verwendet werden kann.

Eine weitere Alternative ist es, nur bei einer einzigen der N Messproben das Lösungsmittel durch deuteriertes/fluoriertes zu ersetzen bzw. lediglich Lösungsmittel einzubringen. Auf diese Weise kann von Fall zu Fall entschieden werden, ob die Messsubstanz in normalem Lösungsmittel gelöst werden soll oder nicht.

Bei der Verwendung eines externen Locks kann die Feldhomogenität nach wie vor mittels protonendetektierten Abbildungsverfahren des statischen Magnetfeldes B₀ bestimmt und korrigiert werden.

### Vergleich mit dem Stand der Technik: Hohlraumresonatoren

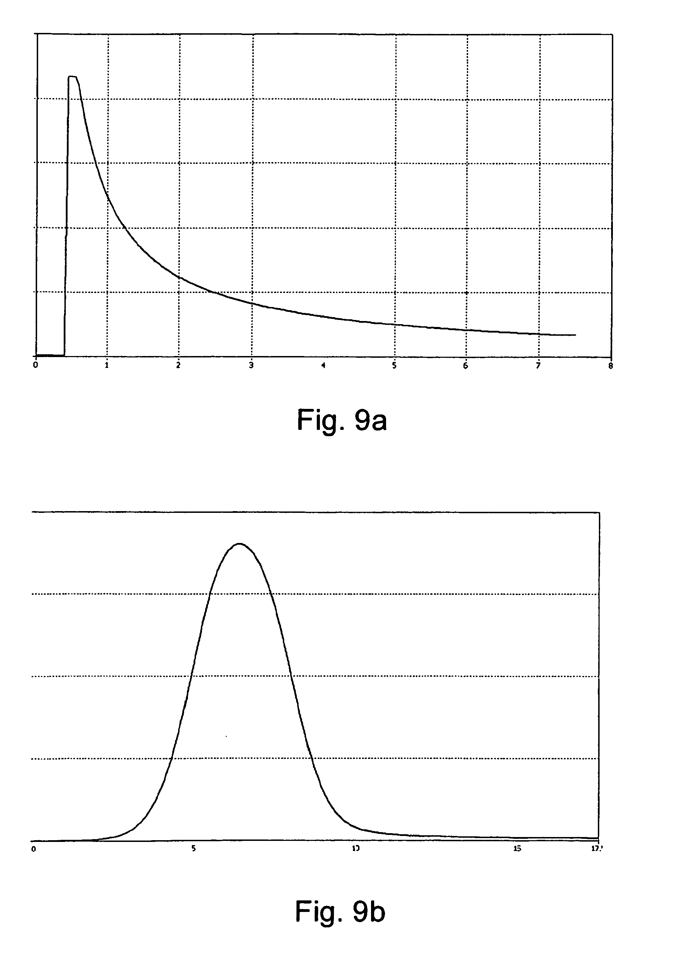

Aus [4] ist ein "Toroid cavity resonator" (Torus-Hohlraum-Resonator) bekannt, der mit einer Vielzahl von Messproben befüllt werden kann. Der Unterschied zur hier vorgestellten Erfindung liegt im Typ des Resonators. Im Betrieb baut sich in einem Hohlraumresonator wie dem in [4] vorgestellten eine stehende Welle auf. Beim angeregten TM Mode zeigt die Feldamplitude in radialer Richtung eine 1/r Abhängigkeit (siehe **Fig. 9a**). Eine solche Feldverteilung ist für die Anforderungen der hochauflösenden NMR völlig unzureichend, da die Homogenität des HF-Feldes deutlich zu schlecht ausfällt. Wird der Resonator nur partiell befüllt, so kann die Homogenität des HF-Feldes über die Messproben zwar verbessert werden, der Füllfaktor fällt jedoch dramatisch ab und die Effizienz des Resonators wird unzureichend. Die höchste Empfindlichkeit besitzt der Hohlraumresonator am Ort der geringsten Homogenität, d.h. in der Nähe des Innenleiters. In [4] wird diese Inhomogenität dazu ausgenutzt, die verschiedenen Messproben, mit denen der Resonator befüllt ist, weitestgehend separat anzuregen (S.2 - Z.20ff.) um so auf eine Gradientenkodierung der Ortsauflösung verzichten zu können.

In der vorgestellten Erfindung ist das Ziel jedoch neben der gesteigerten Effizienz und geringen Abhängigkeit von Verlusten in der Messprobe, eine möglichst homogene Feldverteilung über die Messproben zu erreichen. Dies ist notwendig, um nicht nur für einen einfachen Lesepuls, sondern auch bei mehrdimensionalen Pulssequenzen mit einer Vielzahl von Pulsen dieselbe Empfindlichkeit für über das gesamte Volumen aller Messproben zu erreichen. Der erfindungsgemässe Messkopf hat im Gegensatz zum Hohlraumresonator die höchste Empfindlichkeit am Ort der höchsten Homogenität, wie aus **Fig. 9b** ersichtlich ist. Eine reduzierte Homogenität führt insbesondere bei Inversionspulsen zu drastischen Signaleinbussen, so dass eine 1/r Abhängigkeit des B₁-Feldes über das Messvolumen, wie bei einem Hohlraumresonator nach [4], für die Anforderungen der hochauflösenden NMR inakzeptabel ist.

Die Figuren 9a und 9b zeigen das radiale Feldprofil im Zentrum des Resonators: Fig. 9a für einen Hohlraumresonator nach [4], bei dem die Messproben auf verschiedenen Positionen im Bereich ca. 1 mm bis 7 mm eingebracht werden, und Fig. 9b für den erfindungsgemässen Resonator gemäss Fig. 4b, bei dem alle Messproben ca. bei 6.75 mm montiert werden.

Weiterhin hängt die Resonanzfrequenz eines Hohlraumresonators nur von dessen Geometrie und der Dielektrizitätskonstante der Befüllung ab. Geringfügige Anpassungen können mittels Kapazitäten zwischen dem Innenleiter und der dem Aussenmantel oder metallischen sowie dielektrischen Verdrängern vorgenommen werden.

In der hochauflösenden NMR sind jedoch Messköpfe mit drei oder mehr Kanälen üblich. Diese zusätzlichen Kanäle können bei der Verwendung von Hohlraumresonatoren wie in [4] nicht eingekoppelt werden, da dieser das magnetische Feld auf seinen Innenraum begrenzt (S. 2 Z. 36-37). Ein solcher Resonator ist auch nicht durchlässig für ein HF-Feld von aussen. Dies wird für die Anwendung von [4] als Vorzug gewertet, ist für den Bau eines Mehrkanalprobenkopfes aber nicht brauchbar.

### Vergleich mit dem Stand der Technik: multiple Messproben

Aus den Referenzen [7-11] sind NMR-Messsysteme bekannt, die eine Vielzahl von Detektionssystemen verwenden, um gleichzeitig oder kurzfristig nacheinander Spektroskopie mit einer Vielzahl von Messproben durchführen zu können. Hierbei sollten die einzelnen Detektionsspulen jedoch nach Möglichkeit nicht mit einander koppeln, da sonst die spektrale Information der verschiedenen Messproben nicht separat gesammelt werden könnte. Weiterhin werden die multiplen Detektionssysteme jeweils separat angekoppelt, getuned und gematched sowie die Information separat im Spektrometer verarbeitet.
[9] beschreibt ein System, bei dem zwar die Sende und Empfangsspulen vielzählig sind, aber das Spektrometer mittels Umschalter zwischen diesen Spulen geschaltet wird.
[10 und 11] beschreiben jeweils ein System, bei dem mehrere Durchflusszellen mit zugehörigen Detektionsspulen im Messkopf verbaut werden.
[8] beschreibt auch ein System, bei dem mit einer einzigen konventionellen Detektionsapparatur gemessen werden kann, jedoch wird dies nur im Zusammenhang mit Messproben, die verschiedene spektrale Bereiche belegen verwendet ("samples of disparate character"). Hierbei werden die Messproben in der z-Richtung übereinander positioniert. Die dortige Fig. 6 zeigt eine Anordnung, bei der die Messproben auch nicht axial übereinander, sondern nebeneinander positioniert werden.

Der Unterschied zu der hier vorgestellten Erfindung liegt insbesondere in folgenden Punkten:

Erfindungsgemäss wird dieselbe Messsubstanz auf verschiedene Messproben verteilt, es werden nicht unterschiedliche Messsubstanzen in den verschiedenen Messproben verwendet.

Weiterhin koppeln die Resonatorsysteme, die die einzelnen Messproben umgeben so stark miteinander, dass ein gekoppelter Mode ("Torusmode") entsteht. Dieser Mode wird lediglich ein einziges Mal angekoppelt, alle Resonatorsysteme werden gemeinsam getuned. Die spektroskopische Information aus den einzelnen Messproben kann nicht lokal zugeordnet werden. Würden verschiedene Messproben verwendet, so würden sich deren Signale überlagern und eine Analyse wäre nicht mehr möglich.

Zusammenfassend beschreibt die Erfindung einen NMR-Messkopf, bei dem mehrere Grundelemente mit jeweils einer Messprobe und einem Resonatorsystem (das ist ein ein- oder mehrteiliger Resonator) vorgesehen sind. Diese Resonatorsysteme sind durch entsprechende Geometrie (Platzierung) und Ansteuerung (nur ein elektronisches Kopplungsnetzwerk, gemeinsamer Sende- und Empfängerschaltkreis) so miteinander gekoppelt (bzw. verschaltet durch elektromagnetische Kopplung), dass ein gemeinsamer Mode beim Senden und Empfangen zur Verfügung steht. Dieser gestattet eine Vermessung aller Messproben der Grundelemente wie eine einzige Probe (simultane Messung); es wird keine selektive Information bezüglich der einzelnen Messproben, sondern nur eine globale Information für alle Messproben gewonnen. Auf die Messproben wird eine einzige Probe (Messsubstanz) gleichmäßig aufgeteilt; die Messproben sind somit identisch. Im gekoppelten Mode erfahren alle Messproben ein im Wesentlichen gleiches und homogenes B₁-Feld. Der gemeinsame Mode entsteht bevorzugt über eine positive Gegeninduktivität der einzelnen Resonatorsysteme zu ihren jeweiligen benachbarten Resonatorsystemen. Die Resonatorsysteme sind typischerweise in einem kreisförmigen Ring angeordnet, und das erzeugte B₁-Feld weist (ebenso wie die Anordnung der Grundelemente) eine Zähligkeit entsprechend der Anzahl der Grundelemente auf. Der Messkopf kann neben dem Resonatorkomplex, der durch die Resonatorsysteme der Grundelemente gebildet wird, noch einen oder mehrere weitere Resonatorkomplexe für weitere Messfrequenzen bzw. Modi aufweisen. Der erfindungsgemäße Probenkopf gestattet eine Vermessung einer zur Verfügung stehenden Menge an Messsubstanz mit verbessertem Signal-zu-Rausch-Verhältnis (SNR).

### Literatur:

### a) Lösungsmittelverluste

[1] US 7 068 034 / US 6 917 201, De Swiet, "Squashed liquid NMR sample tubes and RF coils"

### b) Torusresonatoren

[2] US 5 045 793, Rathke, "Toroids as NMR detectors in metal pressure probes and in flow systems"
[3] US 6 788 064, Gerald et al., "Passively shimmed principal detector elements for toroid cavity detector NMR probes"
[4] US 5 574 370, Woelk et al., "Nuclear resonance tomography with a toroid cavity detector"
[5] "Computing the B1 field of the toroidal MRI coil" Butterworth and Gore, J. Magn. Reson. 175, 114-123 (2005)

### c) aufgereihte Resonatoren

[6] US 5 003 265, Leussler, "Magnetic resonance imaging apparatus comprising an rf coil system"

### d) Multiple Messproben

[7] US 2004164738 / WO 00 50924, Raftery et al., Nuclear magnetic resonance analysis of multiple samples"
[8] US 4 654 592, Zens, "Concurrent NMR analysis of multiple samples."
[9] US 6 456 072, Webb et al., "Method and apparatus for simultaneous acquisition of high resolution NMR spectra from multiple samples"
[10] US 2005253587, Peck et al., "Microfludic device with multiple microcoil NMR detectors"
[11] US 2006164088, Hawkes, "Nmr apparatus for concurrent analysis of multiple samples using a receiver coil array"

## Patentansprüche

1. NMR-Messkopf, umfassend N Grundelemente (10a, 10b, 10c), mit N ≥ 2, wobei jedes Grundelement (10a, 10b, 10c) eine zylinderförmige Messprobe (11) und ein Resonatorsystem (12a, 12b, 12c) aufweist,
wobei die N Messproben (11) eine identische Messsubstanz enthalten,
wobei ein Kopplungsnetzwerk für die N Resonatorsysteme (12a, 12b, 12c) vorgesehen ist, mit dem die Gesamtheit der N Resonatorsysteme (12a, 12b, 12c) beim Senden und Empfangen in einem identischen, gekoppelten Mode betreibbar ist,
wobei die N Resonatorsysteme (12a, 12b, 12c) der N Grundelemente (10a, 10b, 10c) zur Einrichtung des gekoppelten Mode durch elektromagnetische Kopplung miteinander verschaltet sind,
und wobei das Kopplungsnetzwerk für die Gesamtheit der N Resonatorsysteme (12a, 12b, 12c) einen gemeinsamen Empfänger-Schaltkreis umfasst,
**dadurch gekennzeichnet,**
**dass** die Art der Messsubstanz und die Anzahl N der Grundelemente (10a, 10b, 10c) so ausgewählt sind, dass das Rauschen der Messproben (11) das Gesamtrauschen des NMR-Messkopfs dominiert.

2. NMR-Messkopf nach Anspruch 1, **dadurch gekennzeichnet, dass** die N Grundelemente (10a, 10b, 10c) ringförmig, insbesondere kreisringförmig, angeordnet sind.

3. NMR-Messkopf nach Anspruch 2, **dadurch gekennzeichnet, dass** der NMR-Messkopf dazu ausgebildet ist, einen Torusmode zu erzeugen, bei dem durch alle N Messproben (11) eine gemeinsame, ringförmig geschlossene B1-Magnetfeldlinie verläuft.

4. NMR-Messkopf nach Anspruch 2, **dadurch gekennzeichnet, dass** der NMR-Messkopf dazu ausgebildet ist, einen N-Tupol Mode zu erzeugen, bei dem durch je zwei benachbarte Messproben (11) eine gemeinsame, ringförmig geschlossene B1-Magnetfeldlinie verläuft.

5. NMR-Messkopf nach einem der Ansprüche 2 bis 4, **dadurch gekennzeichnet, dass** im Zentrum der ringförmigen Anordnung von Grundelementen (10a, 10b, 10c) eine Lockspule (51) angeordnet ist.

6. NMR-Messkopf nach einem der vorhergehenden Ansprüche, **dadurch gekennzeichnet, dass** die N zylinderförmigen Messproben (11) jeweils eine gleiche Menge der identischen Messsubstanz enthalten.

7. NMR-Messkopf nach einem der Ansprüche 1 bis 6, **dadurch gekennzeichnet, dass** die N Resonatorsysteme (12a, 12b, 12c) als Sattelspulen (12a) ausgebildet sind,
insbesondere dass die N Resonatorsysteme (12a, 12b, 12c) als Alderman-Grant-Resonatoren oder als Birdcage-Resonatoren ausgebildet sind.

8. NMR-Messkopf nach Anspruch 7, **dadurch gekennzeichnet, dass** der NMR-Messkopf eine kreisringförmige Anordnung von Sattelspulen (12a) aufweist, wobei jeweils eine Messprobe (11) im Inneren einer jeden Sattelspule (12a) angeordnet ist, und die Leiterfenster (13) einer jeden Sattelspule (12a) jeweils ihren beiden benachbarten Sattelspulen (12a) zugewandt sind.

9. NMR-Messkopf nach einem der Ansprüche 1 bis 6, **dadurch gekennzeichnet, dass** die N Resonatorsysteme (12a, 12b, 12c) als planare Helmholz-Spulen (12b) oder als planare Resonatoren (12c) ausgebildet sind.

10. NMR-Messkopf nach Anspruch 9, **dadurch gekennzeichnet, dass** der NMR-Messkopf eine kreisringförmige Anordnung von planaren Helmholz-Spulen (12b) umfasst, wobei jeweils eine Messprobe (11) im Inneren einer planaren Helmholz-Spule (12b) angeordnet ist, und die planaren Helmholz-Spulen (12b) mit ihren ebenen Substratplättchen (14) radial ausgereichtet sind.

11. NMR-Messkopf nach Anspruch 9, **dadurch gekennzeichnet, dass** der NMR-Messkopf eine kreisringförmige Anordnung von planaren Resonatoren (12c) umfasst, wobei jeweils zwischen zwei aufeinander folgenden planaren Resonatoren (12c) eine Messprobe (11) angeordnet ist, und wobei die planaren Resonatoren (12c) jeweils radial ausgereichtet sind.

12. NMR-Messkopf nach einem der Ansprüche 9 bis 11, **dadurch gekennzeichnet, dass** die N Resonatorsysteme (12b, 12c) Leiterbahnen (15) aus Hochtemperatur-Supraleiter aufweisen.

13. NMR-Messkopf nach einem der vorhergehenden Ansprüche, **dadurch gekennzeichnet, dass** für die Anzahl N der Grundelemente (10a, 10b, 10c) gilt:
N ≥ 6, bevorzugt N ≥ 8, und besonders bevorzugt N ≥ 12.

14. NMR-Messkopf nach einem der vorhergehenden Ansprüche, **dadurch gekennzeichnet, dass** die N Grundelemente (10a, 10b, 10c) einen ersten Resonatorkomplex (70/71, 72, 73) für eine erste Messfrequenz bilden, und dass der Messkopf mindestens einen zusätzlichen Resonatorkomplex (70/71, 72, 73) für eine weitere Messfrequenz aufweist,
insbesondere wobei der zusätzliche Resonatorkomplex (70/71, 72, 73) als Sattelspule ausgebildet ist, in deren Innerem die N Grundelemente angeordnet sind.

## Claims

1. Nuclear magnetic resonance (= NMR) probehead, comprising N basic elements (10a, 10b, 10c), where N ≥ 2, wherein each basic element (10a, 10b, 10c) comprises a cylindrical measurement sample (11) and a resonator system (12a, 12b, 12c), wherein the N measurement samples (11) contain an identical measuring substance, wherein a coupling network for the N resonator systems (12a, 12b, 12c) is provided, with which the totality of the N resonator systems (12a, 12b, 12c) can be operated in one identical, coupled mode during transmission and reception,
wherein the N resonator systems (12a, 12b, 12c) of the N basic elements (10a, 10b, 10c) are connected to each other for setting up the coupled mode through electromagnetic coupling, and wherein the coupling network comprises one common receiver circuit for the totality of the N resonator systems (12a, 12b, 12c),
**characterized in that**
the type of the measuring substance and the number N of the basic elements (10a, 10b, 10c) are selected in such a manner that the noise of the measurement samples (11) dominates the total noise of the NMR probehead.

2. NMR probehead according to claim 1, **characterized in that** the N basic elements (10a, 10b, 10c) are disposed in a ring-shaped, in particular circular ring-shaped fashion.

3. NMR probehead according to claim 2, **characterized in that** the NMR probehead is constituted in such a way as to generate a toroidal mode, in which a common, ring-shaped closed B1 magnetic field line runs through all N measurement samples (11).

4. NMR probehead according to claim 2, **characterized in that** the NMR probehead is constituted so as to generate an N-tupole mode, in which a common, ring-shaped closed B1 magnetic field line runs through pairs of adjacent measurement samples (11) in each case.

5. NMR probehead according to any one of the claims 2 to 4, **characterized in that** a lock coil (51) is disposed at the center of the ring-shaped configuration of basic elements (10a, 10b, 10c).

6. NMR probehead according to any one of the previous claims, **characterized in that** the N cylindrical measurement samples (11) each comprise an identical amount of the identical measuring substance.

7. NMR probehead according to any one of the claims 1 to 6, **characterized in that** the N resonator systems (12a, 12b, 12c) are constituted as saddle coils (12a),
in particular that the N resonator systems (12a, 12b, 12c) are constituted as Alderman-Grant resonators or as birdcage resonators.

8. NMR probehead according to claim 7, **characterized in that** the NMR probehead exhibits a circular ring-shaped configuration of saddle coils (12a), wherein a measurement sample (11) is disposed inside each saddle coil (12a), and the conductor windows (13) of each saddle coil (12a) face their two adjacent saddle coils (12a).

9. NMR probehead according to any one of the claims 1 to 6, **characterized in that** the N resonator systems (12a, 12b, 12c) are constituted as planar Helmholtz coils (12b) or as planar resonators (12c).

10. NMR probehead according to claim 9, **characterized in that** the NMR probehead comprises a circular ring-shaped configuration of planar Helmholtz coils (12b), wherein a measurement sample (11) is disposed inside each planar Helmholtz coil (12b), and wherein the planar Helmholtz coils (12b) with their flat substrate plates (14) are aligned radially.

11. NMR probehead according to claim 9, **characterized in that** the NMR probehead comprises a circular ring-shaped configuration of planar resonators (12c), wherein a measurement sample (11) is disposed between each pair of consecutive planar resonators (12c), and wherein the planar resonators (12c) are each aligned radially.

12. NMR probehead according to any one of the claims 9 to 11, **characterized in that** the N resonator systems (12b, 12c) have conductor paths (15) made of high-temperature superconductor.

13. NMR probehead according to any one of the previous claims, **characterized in that** for the number N of basic elements (10a, 10b, 10c) the following applies: N ≥ 6, preferably N ≥ 8, and especially preferably N ≥ 12.

14. NMR probehead according to any one of the previous claims, **characterized in that** the N basic elements (10a, 10b, 10c) form a first resonator complex (70/71, 72, 73) for a first measurement frequency, and that the probehead comprises at least one additional resonator complex (70/71, 72, 73) for a further measuring frequency, in particular, wherein the additional resonator complex (70/71, 72, 73) is constituted as a saddle coil, inside which the N basic elements are disposed.

## Revendications

1. Tête de mesure RMN, comprenant N éléments de base (10a, 10b, 10c), avec N ≥ 2, chaque élément de base (10a, 10b, 10c) présentant un échantillon de mesure cylindrique (11) et un système de résonateur (12a, 12b, 12c), les N échantillons de mesure (11) contenant une substance de mesure identique, un réseau de couplage pour les N systèmes de résonateur (12a, 12b, 12c) étant prévu, lequel permet de faire fonctionner la totalité des N systèmes de résonateur (12a, 12b, 12c) dans un mode couplé identique lors de l'émission et de la réception,
les N systèmes de résonateur (12a, 12b, 12c) des N éléments de base (10a, 10b, 10c) étant couplés entre eux par couplage électromagnétique pour établir le mode couplé,
et le réseau de couplage pour la totalité des N systèmes de résonateur (12a, 12b, 12c) comprenant un circuit récepteur commun,
**caractérisé en ce**
**que** la nature de la substance de mesure et le nombre N d'éléments de base (10a, 10b, 10c) sont sélectionnés de façon que le bruit des échantillons de mesure (11) domine le bruit total de la tête de mesure RMN.

2. Tête de mesure RMN selon la revendication 1, **caractérisée en ce que** les N éléments de base (10a, 10b, 10c) sont disposés en forme d'anneau, en particulier en forme d'anneau circulaire.

3. Tête de mesure RMN selon la revendication 2, **caractérisée en ce que** la tête de mesure RMN est conçue pour produire un mode torique dans lequel une ligne de champ magnétique B1 commune, fermée en forme d'anneau, passe à travers tous les N échantillons de mesure (11).

4. Tête de mesure RMN selon la revendication 2, **caractérisée en ce que** la tête de mesure RM est conçue pour produire un mode N-tupolaire dans lequel une ligne de champ magnétique B1 commune, fermée en forme d'anneau, passe à travers chaque fois deux échantillons de mesure (11) adjacents.

5. Tête de mesure RMN selon l'une des revendications 2 à 4, **caractérisée en ce qu'**une bobine de verrouillage (51) est disposée au centre de la disposition annulaire des éléments de base (10a, 10b, 10c).

6. Tête de mesure RMN selon l'une des revendications précédentes, **caractérisée en ce que** les N échantillons de mesure cylindriques (11) contiennent chacun une même quantité de la substance de mesure identique.

7. Tête de mesure RMN selon l'une des revendications 1 à 6, **caractérisée en ce que** les N systèmes de résonateur (12a, 12b, 12c) sont réalisés sous la forme de bobines en selle de cheval (12a),
en particulier que les N systèmes de résonateur (12a, 12b, 12c) sont réalisés sous la forme de résonateurs Alderman-Grant ou de résonateurs en cage d'oiseau.

8. Tête de mesure RMN selon la revendication 7, **caractérisée en ce que** la tête de mesure RMN présente une disposition en anneau circulaire de bobines en selle de cheval (12a), un échantillon de mesure (11) étant disposé à l'intérieur de chaque bobine en selle de cheval (12a), et les fenêtres de conducteur (13) de chaque bobine en selle de cheval (12a) étant chaque fois tournées vers les deux bobines en selle de cheval (12a) qui leur sont adjacentes.

9. Tête de mesure RMN selon l'une des revendications 1 à 6, **caractérisée en ce que** les N systèmes de résonateur (12a, 12b, 12c) sont réalisés sous la forme de bobines de Helmholtz planaires (12b) ou de résonateurs planaires (12c).

10. Tête de mesure RMN selon la revendication 9, **caractérisée en ce que** la tête de mesure RMN comprend une disposition en anneau circulaire de bobines de Helmholtz planaires (12b), un échantillon de mesure (11) étant disposé chaque fois à l'intérieur d'une bobine de Helmholtz planaire (12b) et les bobines de Helmholtz planaires (12b) avec leurs plaquettes de substrat planes (14) étant orientées radialement.

11. Tête de mesure RMN selon la revendication 9, **caractérisée en ce que** la tête de mesure RMN comprend une disposition en anneau circulaire de résonateurs planaires (12c), un échantillon de mesure (11) étant disposé chaque fois entre deux résonateurs planaires (12c) successifs et les résonateurs planaires (12c) étant chaque fois orientés radialement.

12. Tête de mesure RM selon l'une des revendications 9 à 11, **caractérisée en ce que** les N systèmes de résonateur (12b, 12c) présentent des pistes conductrices (15) en supraconducteur à haute température.

13. Tête de mesure RM selon l'une des revendications précédentes, **caractérisée en ce que** pour le nombre N d'éléments de base (10a, 10b, 10c), il s'applique :
N ≥ 6, de préférence N ≥ 8, et de manière particulièrement préférée N ≥ 12.

14. Tête de mesure RMN selon l'une des revendications précédentes, **caractérisée en ce que** les N éléments de base (10a, 10b, 10c) forment un premier complexe de résonateurs (70/71, 72, 73) pour une première fréquence de mesure,
et que la tête de mesure présente au moins un complexe de résonateurs supplémentaire (70/71, 72, 73) pour une autre fréquence de mesure,
en particulier le complexe de résonateurs supplémentaire (70/71, 72, 73) étant réalisé sous la forme d'une bobine en selle de cheval à l'intérieur de laquelle les N éléments de base sont disposés.
